(19)

Europäisches
Patentamt
European
Patent Office
Office européen
des brevets

(11) **EP 3 002 600 A1**

(12) **EUROPEAN PATENT APPLICATION**
published in accordance with Art. 153(4) EPC

(43) Date of publication:
**06.04.2016 Bulletin 2016/14**

(51) Int Cl.:
**G01R 31/36** $^{(2006.01)}$  **H01M 10/48** $^{(2006.01)}$

(21) Application number: **14866824.7**

(22) Date of filing: **05.12.2014**

(86) International application number:
**PCT/KR2014/011969**

(87) International publication number:
**WO 2015/084115 (11.06.2015 Gazette 2015/23)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **05.12.2013 KR 20130150672**

(71) Applicant: **LG Chem, Ltd.
Seoul 07336 (KR)**

(72) Inventors:
- **LEE, Hyun-Chul
  Daejeon 305-380 (KR)**
- **PARK, Jong-Min
  Daejeon 305-380 (KR)**

(74) Representative: **Cabinet Plasseraud
66, rue de la Chaussée d'Antin
75440 Paris Cedex 09 (FR)**

(54) **DEVICE AND METHOD FOR ESTIMATING CAPACITY DEGRADATION OF BATTERY**

(57)    Disclosed is an apparatus and method for estimating the battery state of health (SOH) to enable fast and easy SOH estimation of unused batteries.

The apparatus for estimating the battery SOH according to the present disclosure corresponds to an apparatus for estimating a SOH of an unused battery, and includes a storage unit configured to store manufactured date information of the battery, an estimation date input module configured to receive an input of desired date information for SOH estimation of the battery, an elapsed day calculation module configured to calculate elapsed days between the manufactured date of the battery and the desired date for SOH estimation of the battery using the desired date information for SOH estimation and the manufactured date information of the battery, and a SOH estimation module configured to estimate the SOH of the battery using the elapsed days calculated by the elapsed days calculation module.

**FIG. 1**

EP 3 002 600 A1

**Description**

TECHNICAL FIELD

The present disclosure relates to technology for estimating the battery state of health (SOH), and more particularly, to an apparatus and method for estimating the battery SOH to enable fast and easy SOH estimation of unused batteries.

The present application claims priority to Korean Patent Application No. 10-2013-0150672 filed in the Republic of Korea on December 5, 2013, the disclosures of which are incorporated herein by reference.

BACKGROUND ART

Recently, with the dramatically increasing demands for portable electronic products such as laptop computers, video cameras, and mobile phones, and competitive development of storage batteries for energy storage, robots, and satellites, studies are actively being conducted on high performance secondary batteries that can be recharged and used repeatedly.

Currently, available secondary batteries include nickel-cadmium batteries, nickel-hydrogen batteries, nickel-zinc batteries, lithium secondary batteries, and the like, and among them, lithium secondary batteries are gaining attention due to advantages of charging and discharging freely in the absence of a memory effect, a very low self-discharge rate, and a high energy density as compared to nickel-based secondary batteries.

However, secondary batteries naturally deteriorate with the passage of time, or by repeated charge and discharge, secondary batteries deteriorate and their performance degrades. Thus, in the use of secondary batteries, technology for quantitative evaluation of the state of health (SOH) is required.

Generally, an aging level, also known as SOH, is a parameter that quantitatively describes a change in capacity characteristics of a battery, and indicates an extent to which the battery capacity fades. Thus, using the SOH, battery replacement may be conducted at a proper time, and over-charge and over-discharge of the battery may be prevented by controlling the charge/discharge capacity of the battery based on the period of time during which the battery has been used.

There are various methods of estimating the SOH, including, for example, a method of estimating the SOH using the internal resistance and temperature of batteries, and a method of estimating the SOH through a full discharge test. However, traditional methods of estimating the SOH primarily measure electrical parameters of batteries and estimate the SOH through a complex calculation operation. Such methods have drawbacks of a complex calculation operation and a high-specification calculator needed for technical implementation.

Also, existing technology for SOH estimation methods has been only developed to accurately estimate the SOH on the premise that the SOH changes irregularly by the use of batteries, and SOH estimation of unused batteries is yet unexploited. That is, according to a related art, even when unused batteries naturally deteriorate over time, there is inconvenience in estimating the battery SOH using a complex estimation method.

DISCLOSURE

Technical Problem

The present disclosure is designed to solve the above problem, and therefore, the present disclosure is directed to providing an apparatus for estimating the battery state of health (SOH) to enable convenient and fast SOH estimation of unused batteries.

The other objects and advantages of the present disclosure will be apparent from the following description and the exemplary embodiments of the present disclosure. Also, it will be readily understood that the objects and advantages of the present disclosure are realized by the means and combinations thereof set forth in the appended claims.

Technical Solution

To achieve the object, an apparatus for estimating the battery state of health (SOH) according to one aspect of the present disclosure corresponds to an apparatus for estimating a SOH of an unused battery, and the apparatus includes a storage unit configured to store manufactured date information of the battery, an estimation date input module configured to receive an input of desired date information for SOH estimation of the battery, an elapsed day calculation module configured to calculate elapsed days between the manufactured date of the battery and the desired date for SOH estimation of the battery using the desired date information for SOH estimation and the manufactured date information of the battery, and a SOH estimation module configured to estimate the SOH of the battery using the elapsed days calculated by the elapsed day calculation module.

Preferably, the elapsed day calculation module may calculate the elapsed days through the following relation equation:

$$\left(Y_N \times 365 + M_N \times \frac{365}{12} + D_N\right) - \left(Y_I \times 365 + M_I \times \frac{365}{12} + D_I\right)$$

where $Y_N$, $M_N$, and $D_N$ denote desired year, month, and date for SOH estimation, respectively, and $Y_I$, $M_I$, and $D_I$ denote manufactured year, month, and date of the battery, respectively.

Also, preferably, the storage unit may further store a SOH table representing elapsed days from the manufactured date of the battery and SOHs corresponding to the elapsed days, and the SOH estimation module may estimate the SOH of the battery by searching for the elapsed days calculated by the elapsed day calculation module in the SOH table.

Also, preferably, the desired date for SOH estimation may be the day at which SOH estimation of the battery is performed.

More preferably, the estimation date input module may receive the input of the date information from a battery management system (BMS) equipped in a battery pack.

To achieve the object, a battery pack according to another aspect of the present disclosure includes the above apparatus for estimating the battery SOH.

To achieve the object, a method for estimating the battery SOH according to still another aspect of the present disclosure corresponds to a method for estimating a SOH of an unused battery, and the method includes storing manufactured date information of the battery, receiving an input of desired date information for SOH estimation of the battery, calculating elapsed days between the manufactured date of the battery and the desired date for SOH estimation of the battery using the desired date information for SOH estimation and the manufactured date information of the battery, and estimating the SOH of the battery using the elapsed days calculated in the step of calculating the elapsed days.

Preferably, the step of calculating the elapsed days may include calculating the elapsed days through the following relation equation:

$$\left(Y_N \times 365 + M_N \times \frac{365}{12} + D_N\right) - \left(Y_I \times 365 + M_I \times \frac{365}{12} + D_I\right)$$

where $Y_N$, $M_N$, and $D_N$ denote desired year, month, and date for SOH estimation, respectively, and $Y_I$, $M_I$, and $D_I$ denote manufactured year, month, and date of the battery, respectively.

Also, preferably, the method for estimating the battery SOH may further include storing a SOH table representing elapsed days from the manufactured date of the battery and SOHs corresponding to the elapsed days, and the step of estimating the SOH may include estimating the SOH of the battery by searching for the elapsed days calculated in the step of calculating the elapsed days in the SOH table.

Also, preferably, the desired date for SOH estimation may be the day at which SOH estimation of the battery is performed.

More preferably, the step of receiving the input of the desired date for estimation may include receiving the input of the date information from a BMS equipped in a battery pack.

Advantageous Effects

According to the present disclosure, the state of health (SOH) of unused batteries may be estimated without using a complex SOH estimation method. Thus, the SOH of unused batteries may be estimated more conveniently and quickly.

Particularly, the present disclosure estimates the SOH of a battery using the desired date for SOH estimation of the battery and the manufactured date of the battery rather than accurate calendar dates according to the Almanac, therefore, according to one aspect of the present disclosure, the battery SOH may be estimated more conveniently and quickly as compared to that of accurate calendar dates according to the Almanac.

Besides, the present disclosure may have a variety of different effects, and other effects of the present disclosure can be understood by the following description and will become apparent from the embodiments of the present disclosure.

BRIEF DESCRIPTION OF THE DRAWINGS

The accompanying drawings illustrate a preferred embodiment of the present disclosure and together with the foregoing disclosure, serve to provide further understanding of the technical spirit of the present disclosure, and thus, the present disclosure is not construed as being limited to the drawing.

FIG. 1 is a block diagram schematically illustrating the functional configuration of an apparatus for estimating the battery state of health (SOH) according to an exemplary embodiment of the present disclosure.
FIG. 2 is a diagram illustrating an example of a SOH table according to the present disclosure.
FIG. 3 is a diagram schematically illustrating a method for estimating the battery SOH according to an exemplary embodiment of the present disclosure.

## MODE FOR CARRYING OUT THE INVENTION

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the spirit and scope of the disclosure.

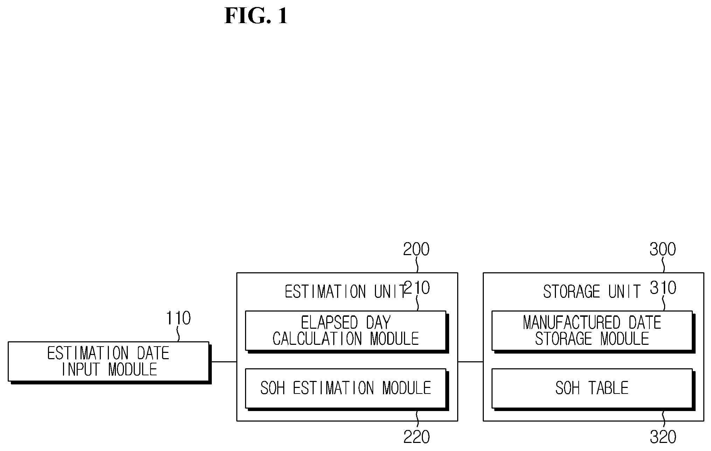

FIG. 1 is a block diagram schematically illustrating the functional configuration of an apparatus for estimating the battery state of health (SOH) according to an exemplary embodiment of the present disclosure.

Referring to FIG. 1, the apparatus for estimating the battery SOH according to the present disclosure includes a storage unit 300, an estimation date input module 110, an elapsed day calculation module 210, and a SOH estimation module 220. Particularly, the apparatus for estimating the battery SOH according to the present disclosure corresponds to an apparatus for estimating the SOH of an unused battery.

The storage unit 300 may store manufactured date information of a battery. Here, the manufactured date information of the battery corresponds to information about the date at which the battery became sufficient to carry out charge and discharge through many processes, and includes manufactured year, month, and date information. For example, when the battery is manufactured on August 31, 2013, the storage unit 300 may store information of year 2013, month August, date 31st. The storage unit 300 may be implemented as various devices which performs a storage function, and may also store information other than the manufactured date information of the battery.

The estimation date input module 110 may receive an input of desired date information for SOH estimation of the battery. Here, the desired date information for SOH estimation of the battery includes desired year, month, and date information for SOH estimation of the battery. For example, when the battery is manufactured on August 31, 2013, if a user desires to know the SOH of the battery on a particular date after August 31, 2013, for example, August 31, 2014, the user may input date information of August 31, 2014, and the estimation date input module 110 may receive an input of desired date information for SOH estimation of the battery from the user.

Preferably, the desired date for SOH estimation of the battery is the date at which SOH estimation of the battery is performed. This is because there are more requests for SOH estimation of the battery at a present point in time than SOH estimation of the battery on a particular date in the past or future. That is, in the above example, August 31, 2014 is preferably the date at which SOH estimation of the battery is performed.

Also, the estimation date input module 110 may receive the input of desired date information for SOH estimation of the battery by various means and/or methods. For example, as described above, the estimation date input module 110 may receive the input of date information directly from a user, or may receive the input of date information at the present point in time from a network such as a mobile communication network, and may receive the input of date information by various means and/or methods not listed in the specification. Preferably, the estimation date input module 110 receives the input of date information from a battery management system (BMS) equipped in a battery pack. That is, the apparatus for estimating the battery SOH according to the present disclosure may be included as one element of the battery pack, and in this case, the estimation date input module 110 may receive the input of date information from the BMS equipped in the battery pack through communication with the BMS. Preferably, the estimation date input module 110 receives the input of date information at the point in time when SOH estimation is performed.

The elapsed day calculation module 210 may calculate elapsed days between the manufactured date of the battery and the desired date for SOH estimation of the battery. In this instance, the elapsed day calculation module 210 may calculate the elapsed days using the manufactured date information of the battery stored in the storage unit 300 and the date information received by the estimation date input module 110.

For example, the storage unit 300 may store a rule concerning Almanac, and the elapsed day calculation module 210 may calculate the elapsed days between the manufactured date of the battery and the desired date for SOH estimation based on the Almanac. More specifically, the storage unit 300 may store calendar information about a solar calendar, and the elapsed day calculation module 210 may calculate the elapsed days between the manufactured date of the battery and the desired date for SOH estimation.

For example, assume that the manufactured date of the battery is August 31, 2013, and the desired present date for SOH estimation is February 15, 2014. According to the solar calendar, September has 30 days, October has 31 days, November has 30 days, December 31 days, and January has 31 days. Because the present date is February 15, 2014, the number of elapsed days in February is 15 days. As a sum of the days is 168 days (30+31+30+31+31+15), the number of elapsed days between the manufactured date of the battery and the desired date for SOH estimation is 168 days.

In this instance, a method of calculating the elapsed days is not limited to this example, and of course, the elapsed days may be calculated by a variety of other methods.

Preferably, the elapsed day calculation module 210 may calculate the elapsed days through the following relation equation:

$$\left(Y_N \times 365 + M_N \times \frac{365}{12} + D_N\right) - \left(Y_I \times 365 + M_I \times \frac{365}{12} + D_I\right)$$

Here, $Y_N$, $M_N$, and $D_N$ denote desired year, month, and date for SOH estimation, respectively, and $Y_I$, $M_I$, and $D_I$ denote manufactured year, month, and date of the battery, respectively.

That is, the relation equation does not calculate elapsed days according to the accurate Almanac, and under the assumption that a year has 365 days and January has 365/12 days, calculates elapsed days as a difference between a value obtained by converting desired date information for SOH estimation to days and a value obtained by converting manufactured date information of the battery to days.

In the same example as the example cited in the method of calculating the elapsed days according to the Almanac, the manufactured date of the battery is August 31, 2013 and the desired present date for SOH estimation is February 15, 2014. Because a value obtained by converting the desired date information for SOH estimation to days is $2014 \times 365 + 2 \times (365/12) + 15$ and a value obtained by converting the manufactured date of the battery to days is $2013 \times 365 + 8 \times (365/12) + 31$, a difference between the value obtained by converting the desired date information for SOH estimation to days ($2014 \times 365 + 2 \times (365/12) + 15 = 735185.83$) and the value obtained by converting the manufactured date of the battery to days ($2013 \times 365 + 8 \times (365/12) + 31 = 735019.33$) is 166.5. That is, the number of elapsed days by the relation equation is 166.5 days.

As compared to the elapsed day calculation method according to the Almanac, there is a difference of 1.5 days between the number of elapsed days by the relation equation and the accurate number of elapsed days. Considering it takes 10-20 years or longer for unused batteries to naturally deteriorate and perform functions as a battery no longer, the difference of 1.5 days may be regarded as an ignorable difference. To calculate the accurate number of elapsed days according to the Almanac, a rule concerning the Almanac should be stored, and to calculate the number of elapsed days according to the Almanac, a large amount of memory is needed and a high-specification calculator is needed to perform a complex calculation. Particularly, when a solar calendar being widely used is used, considering all information associated with lunar years and lunar months should be stored and such information should be taken into account when calculating the elapsed days, a much larger amount of memory and a high-specification calculator is needed. Thus, with the relation equation, there is an advantage of calculating the elapsed day with an ignorable difference by using a minimum amount of memory and a low-specification calculator.

The SOH estimation module 220 may estimate the SOH of the battery using the elapsed days calculated by the elapsed day calculation module 210. For example, assume the battery deteriorates linearly, the SOH of the battery may be estimated using days elapsed between a point in time at which the battery is manufactured and a point in time at which the battery can be used no longer and a ratio of the elapsed days.

In this instance, the SOH estimation method is not limited to this example, and the SOH may be estimated by a variety of other methods.

Preferably, the SOH estimation module 220 may estimate the SOH of the battery by searching for the elapsed days calculated by the elapsed day calculation module 210 in a SOH table 320. Here, the SOH table 320 represents a table of SOHs corresponding to elapsed days from the manufactured date of the battery, and may be composed of repeated test and/or simulation results. Also, the SOH table 320 may be pre-prepared and stored in the storage unit 300. That is, the storage unit 300 may store the SOH table 320 representing elapsed days from the manufactured date of the battery and SOHs corresponding to the elapsed days.

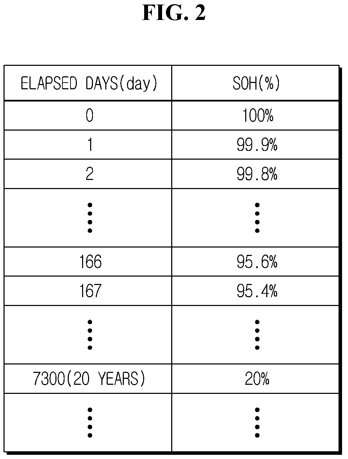

FIG. 2 is a diagram illustrating an example of the SOH table according to the present disclosure.

Referring to FIG. 2, the SOH table 320 representing elapsed days from the manufactured date of the battery and SOHs corresponding to the elapsed days from the manufactured date of the battery is illustrated. When the number of elapsed days is 0, indicating the battery was manufactured on the day, because the capacity degradation of the battery did not occur, the SOH is 100%. Afterwards, with the increasing elapsed days, the battery naturally deteriorates and thus the SOH reduces. In the embodiment of FIG. 2, if 7300 days or 20 years pass, the SOH reduces to 20%. In this instance, the battery may not be evaluated as performing a function as a secondary battery well, and may be replaced with a new one by the user.

In this instance, because the number of elapsed days is 166.5 days in the example, the SOH estimation module 220 may estimate the SOH by searching for 166.5 days in the SOH table 320. Although the SOH table 320 does not include 166.5 days, because 166 days and 167 days are present in the SOH table 320, the SOH estimation module 220 may estimate the SOH, for example, by calculating an arithmetic average value of the SOH of 166 days and the SOH of 167 days. Thus, when the number of elapsed days is 166.5 days, the SOH may be estimated as 95.5%.

A battery pack according to the present disclosure may include the above apparatus for estimating the battery SOH. That is, the apparatus for estimating the battery SOH may be one element of the battery pack. In this instance, the apparatus for estimating the battery SOH may be implemented as a BMS and a storage device provided in the battery pack. That is, because each element of the apparatus for estimating the battery SOH is distinguished logically rather than physically, each element may be implemented as elements of the battery pack.

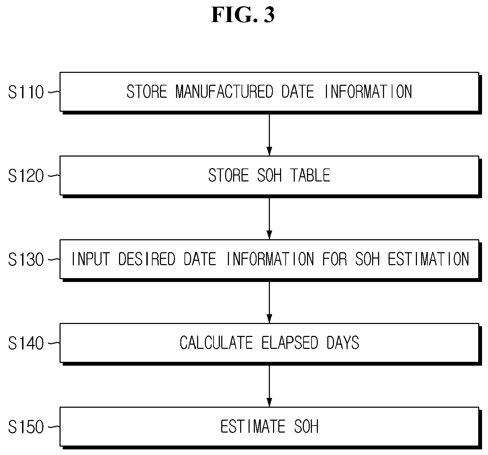

Hereinafter, a method for estimating the battery SOH according to the present disclosure is described with reference to FIG. 3. In FIG. 3, as the subject at each step may be each element of the apparatus for estimating the battery SOH, an overlapping description with the above disclosure is omitted herein.

FIG. 3 is a diagram schematically illustrating a method for estimating the battery SOH according to an exemplary embodiment of the present disclosure.

Referring to FIG. 3, the method for estimating the battery SOH according to the present disclosure corresponds to a method for estimating the SOH of an unused battery, starting with storing manufactured date information of the battery (S110). Subsequently, the method may include receiving an input of desired date information for SOH estimation of the battery (S130). Here, the desired date for SOH estimation of the battery is preferably the very day at which estimation of the SOH of the battery is performed. Also, the step of receiving the input of desired date information for SOH estimation of the battery (S130) may be performed by various methods, preferably, by receiving the input of date information from a BMS equipped in a battery pack.

Subsequently, the method may include calculating elapsed days between the manufactured date of the battery and the desired date for SOH estimation (S140). The step of calculating elapsed days (S140) may calculate the elapsed days using the manufactured date information of the battery stored in S110 and the date information received in S120.

Preferably, the step of calculating the elapsed days (S140) may calculate the elapsed days through the following relation equation:

$$\left(Y_N \times 365 + M_N \times \frac{365}{12} + D_N\right) - \left(Y_I \times 365 + M_I \times \frac{365}{12} + D_I\right)$$

Here, $Y_N$, $M_N$, and $D_N$ denote desired year, month, and date for SOH estimation, respectively, and $Y_I$, $M_I$, and $D_I$ denote manufactured year, month, and date of the battery, respectively.

Subsequently, the method may include estimating the SOH of the battery (S150) using the elapsed days calculated in the step of calculating elapsed days (S140).

Preferably, the step of estimating the SOH of the battery (S150) may estimate the SOH of the battery by searching for the elapsed days calculated in the step of calculating elapsed days in the SOH table 320.

In this instance, before the step S130, the method may further include storing the SOH table 320 representing elapsed days from the manufactured date of the battery and SOHs corresponding to the elapsed days (S120). Although FIG. 3 shows that S120 is performed after S110, S110 and S120 may be performed in an inverse order or the two steps may be performed concurrently.

While the present disclosure has been described in connection with only a limited number of exemplary embodiments and drawings, the present disclosure is not limited thereto and it should be understood that various modifications and changes may be made by those skilled in the art within the spirit of the invention and the appended claims and their equivalents.

Certain features described in the context of separate exemplary embodiments can also be implemented in combination in a single exemplary embodiment. Conversely, various features described in the context of a single exemplary embodiment can also be implemented in multiple exemplary embodiments separately or in any suitable subcombination.

**Claims**

1.  An apparatus for estimating a state of health (SOH) of a battery that estimates a SOH of an unused battery, the apparatus comprising:

    a storage unit configured to store manufactured date information of the battery;
    an estimation date input module configured to receive an input of desired date information for SOH estimation of the battery;
    an elapsed day calculation module configured to calculate elapsed days between the manufactured date of the battery and the desired date for SOH estimation of the battery using the desired date information for SOH estimation and the manufactured date information of the battery; and
    a SOH estimation module configured to estimate the SOH of the battery using the elapsed days calculated by the elapsed day calculation module.

2.  The apparatus for estimating a SOH of a battery according to claim 1, wherein the elapsed day calculation module calculates the elapsed days through the following relation equation:

$$\left(Y_N \times 365 + M_N \times \frac{365}{12} + D_N\right) - \left(Y_I \times 365 + M_I \times \frac{365}{12} + D_I\right)$$

    where $Y_N$, $M_N$, and $D_N$ denote desired year, month, and date for SOH estimation, respectively, and $Y_I$, $M_I$, and $D_I$ denote manufactured year, month, and date of the battery, respectively.

3.  The apparatus for estimating a SOH of a battery according to claim 1, wherein the storage unit further stores a SOH table representing elapsed days from the manufactured date of the battery and SOHs corresponding to the elapsed days, and
    the SOH estimation module estimates the SOH of the battery by searching for the elapsed days calculated by the elapsed day calculation module in the SOH table.

4.  The apparatus for estimating a SOH of a battery according to claim 1, wherein the desired date for SOH estimation is the day at which SOH estimation of the battery is performed.

5.  The apparatus for estimating a SOH of a battery according to claim 4, wherein the estimation date input module receives the input of the date information from a battery management system (BMS) equipped in a battery pack.

6.  A battery pack comprising:

    an apparatus for estimating a SOH of a battery defined in any one of claims 1 through 5.

7.  A method for estimating a state of health (SOH) of a battery that estimates a SOH of an unused battery, the method comprising:

    storing manufactured date information of the battery;
    receiving an input of desired date information for SOH estimation of the battery;
    calculating elapsed days between the manufactured date of the battery and the desired date for SOH estimation of the battery using the desired date information for SOH estimation and the manufactured date information of the battery; and
    estimating the SOH of the battery using the elapsed days calculated in the step of calculating the elapsed days.

8.  The method for estimating a SOH of a battery according to claim 7, wherein the step of calculating the elapsed days comprises calculating the elapsed days through the following relation equation:

$$\left(Y_N \times 365 + M_N \times \frac{365}{12} + D_N\right) - \left(Y_I \times 365 + M_I \times \frac{365}{12} + D_I\right)$$

    where $Y_N$, $M_N$, and $D_N$ denote desired year, month, and date for SOH estimation, respectively, and $Y_I$, $M_I$, and $D_I$ denote manufactured year, month, and date of the battery, respectively.

9. The method for estimating a SOH of a battery according to claim 7, further comprising:

   storing a SOH table representing elapsed days from the manufactured date of the battery and SOHs corresponding to the elapsed days, and
   the step of estimating the SOH comprises estimating the SOH of the battery by searching for the elapsed days calculated in the step of calculating the elapsed days in the SOH table.

10. The method for estimating a SOH of a battery according to claim 7, wherein the desired date for SOH estimation is the day at which SOH estimation of the battery is performed.

11. The method for estimating a SOH of a battery according to claim 10, wherein the step of receiving the input of the desired date for estimation comprises receiving the input of the date information from a battery management system (BMS) equipped in a battery pack.

**FIG. 1**

ESTIMATION DATE INPUT MODULE — 110

ESTIMATION UNIT 200 210
ELAPSED DAY CALCULATION MODULE
SOH ESTIMATION MODULE — 220

STORAGE UNIT 300 310
MANUFACTURED DATE STORAGE MODULE
SOH TABLE — 320

# FIG. 2

| ELAPSED DAYS(day) | SOH(%) |
|:---:|:---:|
| 0 | 100% |
| 1 | 99.9% |
| 2 | 99.8% |
| ⋮ | ⋮ |
| 166 | 95.6% |
| 167 | 95.4% |
| ⋮ | ⋮ |
| 7300(20 YEARS) | 20% |
| ⋮ | ⋮ |

# FIG. 3

S110 — | STORE MANUFACTURED DATE INFORMATION |

S120 — | STORE SOH TABLE |

S130 — | INPUT DESIRED DATE INFORMATION FOR SOH ESTIMATION |

S140 — | CALCULATE ELAPSED DAYS |

S150 — | ESTIMATE SOH |

## INTERNATIONAL SEARCH REPORT

International application No.

**PCT/KR2014/011969**

| A. | CLASSIFICATION OF SUBJECT MATTER |
|---|---|

*G01R 31/36(2006.01)i, H01M 10/48(2006.01)i*

According to International Patent Classification (IPC) or to both national classification and IPC

| B. | FIELDS SEARCHED |
|---|---|

Minimum documentation searched (classification system followed by classification symbols)

G01R 31/36; H01M 10/48; G01N 27/00; H01M 10/42; G08B 21/14; G06F 7/00; H02J 7/00

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)
eKOMPASS (KIPO internal) & Keywords: battery, degeneracy, manufacturing date, SOH

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 09-211091 A (MATSUSHITA ELECTRIC IND CO., LTD.) 15 August 1997<br>See abstract, paragraphs [0013]-[0021] and figures 2-3. | 1-11 |
| Y | JP 2009-193919 A (PANASONIC CORP.) 27 August 2009<br>See abstract, paragraphs [0059]-[0077] and figures 2-3. | 1-11 |
| A | US 2002-0002421 A1 (MUROFUSHI) 03 January 2002<br>See paragraphs [0048]-[0082], claims 1-5 and figures 1-4. | 1-11 |
| A | JP 2003-022486 A (YAZAKI CORP.) 24 January 2003<br>See abstract, claims 1-5 and figures 1-5. | 1-11 |
| A | KR 10-2013-0071957 A (LG CHEM, LTD.) 01 July 2013<br>See abstract, claims 1-7 and figures 1-5. | 1-11 |

| ☐ Further documents are listed in the continuation of Box C. | ☒ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 09 MARCH 2015 (09.03.2015) | **09 MARCH 2015 (09.03.2015)** |

| Name and mailing address of the ISA/KR | Authorized officer |
|---|---|
| Korean Intellectual Property Office<br>Government Complex-Daejeon, 189 Seonsa-ro, Daejeon 302-701, Republic of Korea | |
| Facsimile No. 82-42-472-7140 | Telephone No. |

Form PCT/ISA/210 (second sheet) (July 2009)

INTERNATIONAL SEARCH REPORT
Information on patent family members

International application No.

**PCT/KR2014/011969**

| Patent document cited in search report | Publication date | Patent family member | Publication date |
|---|---|---|---|
| JP 09-211091 A | 15/08/1997 | JP 3136981 B2 | 19/02/2001 |
| JP 2009-193919 A | 27/08/2009 | NONE | |
| US 2002-0002421 A1 | 03/01/2002 | DE 60124174 D1 | 14/12/2006 |
| | | EP 1152366 A2 | 07/11/2001 |
| | | EP 1152366 A3 | 29/01/2003 |
| | | EP 1152366 B1 | 02/11/2006 |
| | | JP 2001-195660 A | 19/07/2001 |
| | | JP 3967055 B2 | 29/08/2007 |
| | | US 6781514 B2 | 24/08/2004 |
| JP 2003-022486 A | 24/01/2003 | NONE | |
| KR 10-2013-0071957 A | 01/07/2013 | KR 10-2014-0051881 A | 02/05/2014 |

Form PCT/ISA/210 (patent family annex) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020130150672